# EUROPEAN PATENT APPLICATION

(11) **EP 1 873 912 A2**
(43) Date of publication of application: **02.01.2008**
(21) Application number: 06254978.7
(22) Date of filing: 26.09.2006
(51) Int. Cl.: H03G 3/30

(54) **Receiver device**

(30) Priority: 28.06.2006 JP 2006177822
(71) Applicant: FUJITSU LIMITED, Kawasaki-shi, Kanagawa 211-8588 (JP)
(72) Inventor: Kuroda, Osamu, Fujitsu Limited, Kawasaki-shi Kanagawa 211-8588 (JP)
(74) Representative: Hitching, Peter Matthew

(57) **Abstract**

A receiver device (1) comprises a gain control portion (40) which regulates a received signal by controlling the opening and closing of a switch (52) which bypasses a first amplifier (12) and providing variable control over the gain of a second amplifier (16), and which also switches the gain of the second amplifier (16) to compensate for gain fluctuations due to the opening and closing of the switch (12). This gain control portion (40) also comprises a digital logic circuit which can program a time offset between the open/closing period of the switch (52) and the switching period of the gain of the second amplifier (16).

## Description

### CROSS REFERENCE TO RELATED APPLICATION

This application is based upon and claims the benefit of priority from the prior Japanese Patent Application No. 2006-177822, filed on June 28, 2006, the entire contents of which being incorporated herein by reference.

### BACKGROUND OF THE INVENTION

### 1. Field of the Invention

The present invention relates to a receiver device which performs automatic gain control to regulate a received signal to a predetermined signal strength. In particular, it relates to a gain control technique in a receiver device which has at least first and second amplifiers connected in series to amplify a received signal, which bypasses the first amplifier depending on the strength of the received signal, and exerts variable control on the gain of the second amplifier in response to the received signal.

### 2. Description of the Related Art

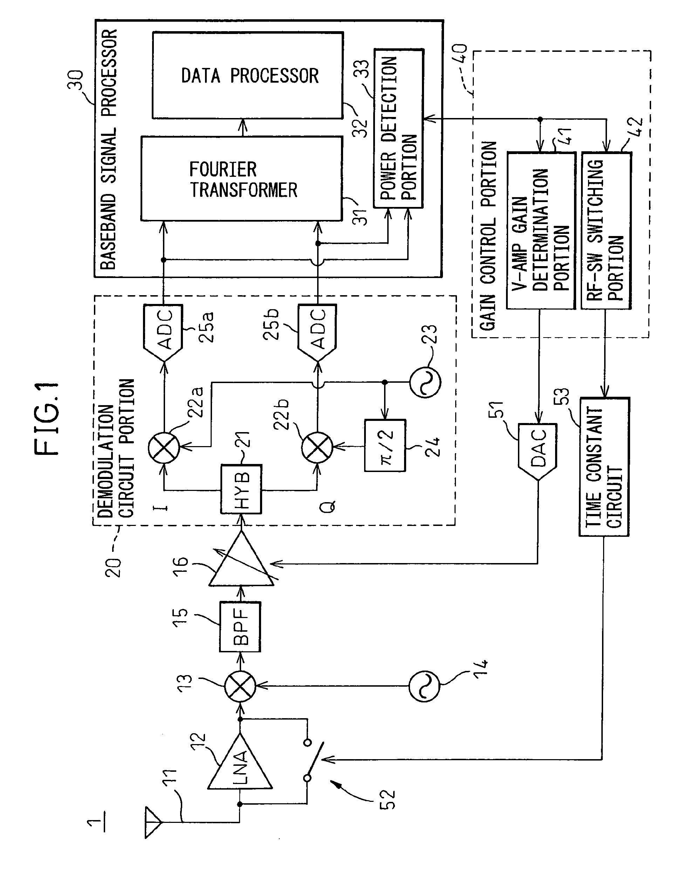

Automatic gain control (AGC) is performed in a receiver device which is used in a portable communications device. If there are fluctuations in incoming signal strength of a signal received through the antenna of the receiver device, the gain within the receiver device is controlled automatically in response to those fluctuations, and thus the strength of the output signal is regulated to a constant value. With recent digital communications devices in particular, the gain within the receiver device is controlled to ensure the optimal signal strength after the demodulation processing or partway through that processing for the number of bits of the signal line which is allocated to that signal, regardless of fluctuations in the incoming signal strength of the digital signal, to guarantee the signal-to-noise ratio (S/N) of a digital signal after demodulation. An example of the configuration of a prior-art OFDM receiver device which provides an automatic gain control function is shown in Fig. 1.

In the example of the configuration of an OFDM receiver device 1 shown in Fig. 1, the device comprises an antenna 11 which receives a radio signal which is an orthogonal frequency-division multiplexed signal (hereinafter called an "OFDM signal); a low-noise amplifier (LNA) 12 which amplifies the signal received by the antenna 11; a frequency converter 13 which mixes a first local signal (LO1 Hz) into the radio-frequency received signal which was amplified by the low-noise amplifier (LNA) 12, to convert it into an intermediate-frequency signal; an oscillator 14 which supplies the first local signal to the frequency converter 13; a band-pass filter (BPF) 15 for extracting just the received signal of a desired intermediate frequency band from the thus-converted intermediate-frequency signal; a variable-gain amplifier (V-AMP) 16 which converts the signal strength of the intermediate-frequency signal extracted by the band-pass filter 15; a demodulation circuit portion 20 which performs orthogonal detection on the analog intermediate-frequency signal which has passed through the variable-gain amplifier 16 and converts it into a digital baseband signal; and a baseband signal processor 30 which demodulates the digital baseband signal into the original data string.

The demodulation circuit portion 20 comprises a divider (HYB) 21 which divides the intermediate-frequency signal which is input from the variable-gain amplifier 16 into two signals; mixers 22a and 22b which mix a second local signal (L02 Hz) at phases of 0° and 90°, respectively, into these intermediate-frequency signals, to form an orthogonal analog baseband signal; an oscillator 23 which supplies the second local signal to the mixers 22a and 22b; a **π**/2 phase shifter 24 which shifts the phase of the second local signal supplied to the mixer 22b by 90°; and analog-digital converters (ADCs) 25a and 25b which convert the orthogonal analog baseband signals converted by the corresponding mixers 22a and 22b into digital signals.

The baseband signal processor 30 comprises a Fourier transformer 31 which performs a Fourier transformation on the received signal, which has been converted into a digital baseband signal by the demodulation circuit portion 20, to demodulate it into the original data string; a data processor 32 which performs various types of predetermined digital data processing on the original data string, and a power detection portion 33 which estimates the incoming signal strength of the received signal, based on the signal strength of the input digital broadband signal and the current gain of the OFDM receiver device. In practice, guard interval removal processing and serial/parallel conversion processing are performed before the Fourier transformation processing, but description thereof is omitted herein.

The OFDM receiver device 1 also comprises a gain control portion 40 which maintains the signal strength of an intermediate-frequency signal which is input to the demodulation circuit portion 20 substantially constant, by performing bypass control of the low-noise amplifier 12 in response to the incoming signal strength which the power detection portion 33 of the baseband signal processor 30 has estimated and/or gain control of the variable-gain amplifier 16.

The gain control portion 40 comprises a V-AMP gain determination portion 41 which exerts variable control over the gain of the variable-gain amplifier 16 in response to the incoming signal strength which the power detection portion 33 of the baseband signal processor 30 has estimated, and an RF-SW switching portion 42 which generates an open/close control signal for a radio-frequency signal switch (RF-SW) 52 which opens and closes the bypass pathway of the low-noise amplifier 12 in response to incoming signal strength. A gain command value of the variable-gain amplifier 16 in digital format, which has been determined by the V-AMP gain determination portion 41, is converted into a gain command value in analog format by a digital/analog converter (DAC), and the gain of the variable-gain amplifier 16 is controlled by that gain command value.

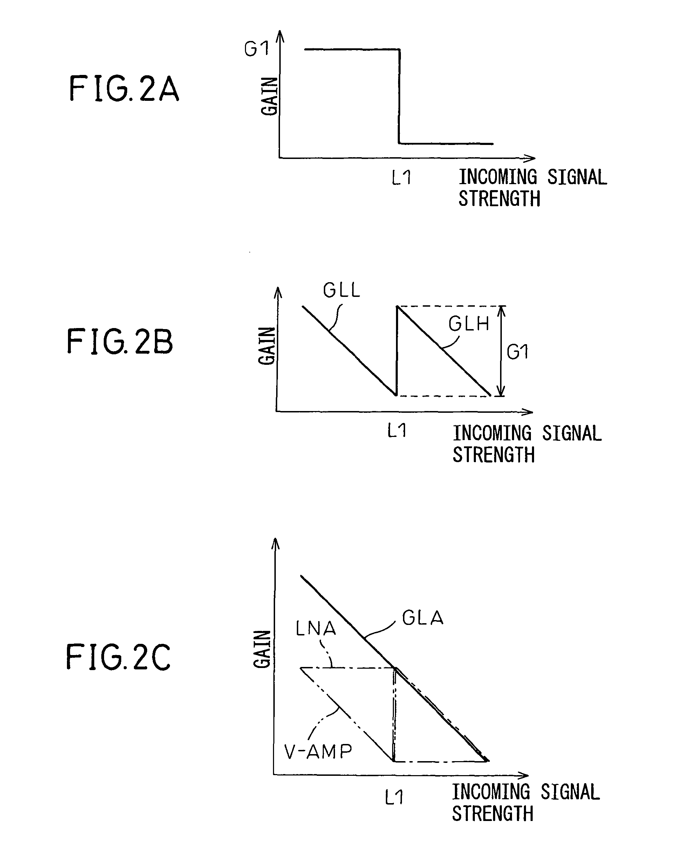

The gain control performed by the gain control portion 40 by using the low-noise amplifier 12 is illustrated in Fig. 2A, the gain control of the variable-gain amplifier 16 by the gain control portion 40 is illustrated in Fig. 2B, and the total gain variations of Figs. 2A and 2B are shown in Fig. 2C.

As shown in Fig. 2A, the RF-SW switching portion 42 of the gain control portion 40 opens the radio-frequency signal switch 52 to halt the bypassing of the low-noise amplifier 12 while the incoming signal strength is weak (incoming signal strength < a threshold value L1), so that the received signal is amplified by a predetermined gain G1, but closes the radio-frequency signal switch 52 when the incoming signal strength is strong (the incoming signal strength ≥ the threshold value L1) and thus the amplification by the low-noise amplifier 12 is unnecessary, so that the received signal bypasses the low-noise amplifier 12.

Meanwhile, the V-AMP gain determination portion 41 exerts variable control over the gain of the variable-gain amplifier 16 in response to reception strength, in accordance with incoming signal strength-gain characteristics (called "gain lines" in this document) GLL and GLH which reduce the gain as the incoming signal strength increases, as shown in Fig. 2B.

If the incoming signal strength varies across the threshold value L1, the amount of gain in the stage before the V-AMP gain determination portion 41 varies by just the predetermined gain G1, because of the switching on and off of the bypass of the low-noise amplifier 12. During this time, the V-AMP gain determination portion 41 switches between the two gain lines GLL and GLH which are separated by just the gain width G1, to compensate for gain fluctuations in the OFDM receiver device 1 concomitant with the presence or absence of bypassing of the low-noise amplifier 12. This gain switching of the variable-gain amplifier 16 produces a gain line GLA for the entire receiver device 1 which is continuous and has a wide variable gain width, as shown in Fig. 2C. More specifically, while the incoming signal strength is weaker than the threshold value L1 and the low-noise amplifier 12 is not bypassed, the V-AMP gain determination portion 41 determines the gain of the variable-gain amplifier 16 in accordance with the comparatively low gain line GLL. While the incoming signal strength is greater than or equal to the threshold value L1 and the low-noise amplifier 12 is bypassed, the V-AMP gain determination portion 41 determines the gain of the variable-gain amplifier 16 in accordance with the gain line GLH which is larger than the gain line GLL by the gain G1.

Note that to enable the V-AMP gain determination portion 41 to determine the gain of the variable-gain amplifier 16 in accordance with the predetermined gain lines, each gain which the variable-gain amplifier 16 ought to have for each incoming signal strength could be written into a gain settings table in which gains are linked to the corresponding incoming signal strengths. This gain settings table is created beforehand and stored in a memory portion (not shown in the figure), and the V-AMP gain determination portion 41 reads out the gain corresponding to the incoming signal strength which the power detection portion 33 has estimated, from which gain settings table.

### SUMMARY OF THE INVENTION

As described above, if the incoming signal strength varies over the threshold value L1, the open/close control of the radio-frequency signal switch 52 to bypass the low-noise amplifier 12 and the gain switching control of the variable-gain amplifier 16 which compensates therefore are performed simultaneously.

In such a case, the variation in gain of the variable-gain amplifier 16 has a response speed which varies with the characteristics of the structural elements and the variation gain width, so that there will be a fairly sluggish change in comparison with the abrupt gain change of the low-noise amplifier 12 at the switchover of the radio-frequency signal switch 52. Thus even if the switching of the gain of the variable-gain amplifier 16 is synchronized with the open/close timing of the radio-frequency signal switch 52, the gain line of the entire OFDM receiver device 1 is not a completely straight line; a slight gain fluctuation occurs at the switching. An example of such gain fluctuations is described below.

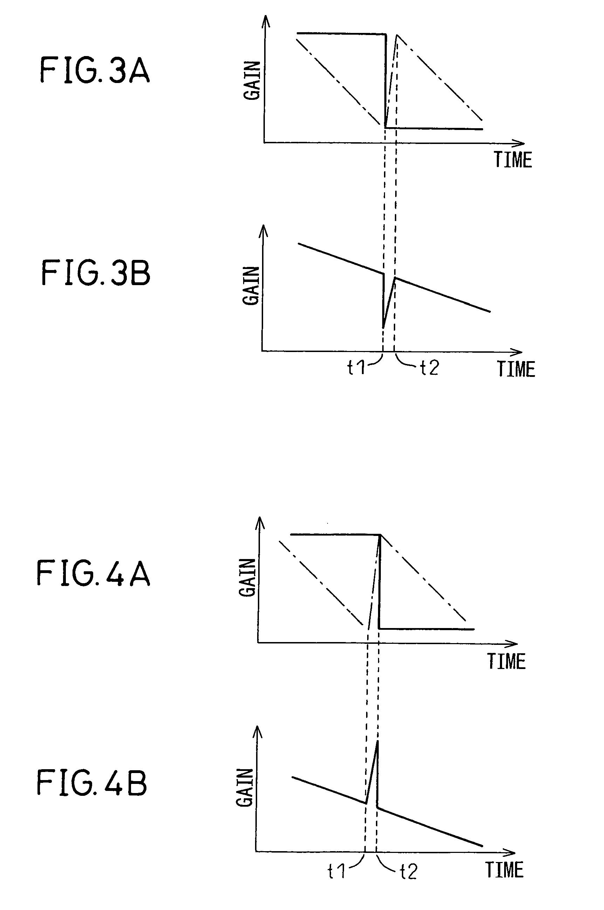

The gain changes shown in Fig. 3A are those when the incoming signal strength increases to exceed the threshold value L1 and the timing of the gain switching of the variable-gain amplifier 16 is slightly delayed with respect to the timing of the opening/closing of the radio-frequency signal switch 52. The solid line in the figure shows the change in gain due to the low-noise amplifier 12 and the broken line shows the change in gain of the variable-gain amplifier 16. As shown in this figure, the gain switching of the variable-gain amplifier 16 starts simultaneously with a closing period t1 of the radio-frequency signal switch 52, but the completion of the gain switching occurs at a time t2 thereafter.

Fig. 3B shows the total of the gain due to the low-noise amplifier 12 and the gain due to the variable-gain amplifier 16, as shown in Fig. 3A. Since the bypassing of the low-noise amplifier 12 occurs before the end of the gain switching of the variable-gain amplifier 16, the overall gain of the receiver device 1 drops briefly during the bypass switching of the low-noise amplifier 12, as shown in the graph.

The gain variations shown in Fig. 4A are those when the incoming signal strength increases to exceed the threshold value L1 and the timing of the gain switching of the variable-gain amplifier 16 is slightly faster than the opening/closing of the radio-frequency signal switch 52. As shown in the figure, the radio-frequency signal switch 52 closes simultaneously with a completion time t2 of the gain switching of the variable-gain amplifier 16.

Fig. 4B shows the total of the gain due to the low-noise amplifier 12 and the gain due to the variable-gain amplifier 16, as shown in Fig. 4A. As shown in the figure, since the gain switching of the variable-gain amplifier 16 starts before the bypassing of the low-noise amplifier 12, the gain of the entire receiver device 1 increases briefly at the bypass switching of the low-noise amplifier 12.

To avoid such gain fluctuations, the OFDM receiver device 1 of the prior art comprises a time constant circuit 53 which causes a delay of a predetermined time in the switching signal to the radio-frequency signal switch 52, to adjust the bypass timing of the low-noise amplifier 12 and the timing of the gain switching of the variable-gain amplifier 16, as shown in Fig. 1.

However, with the method of adjusting the control timing by the time constant circuit 53, the time offset between the timing of the bypassing of the low-noise amplifier 12 and the timing of the gain switching of the variable-gain amplifier 16 can only be set to a fixed time offset, and thus it is difficult to set different time offsets for when switching occurs while the incoming signal strength is increasing and when switching occurs when the incoming signal strength is diminishing.

In addition, the time constant circuit 53 is generally constructed of resistance elements and capacitance elements, but inevitable differences in element characteristics make it difficult to set an accurate time offset.

Furthermore, if the DC offset components of the low-noise amplifier 12 and the variable-gain amplifier 16 are amplified by the above-described gain fluctuations, large transient response components will be generated, which might even reduce the reception capability.

The present invention was devised in the light of the above-described problems with the objective of providing a receiver device which has first and second amplifiers connected in series, such as the above-described low-noise amplifier 12 and variable-gain amplifier 16, which bypasses the first amplifier depending on the incoming signal strength and also exerts variable control over the gain of the second amplifier depending on the incoming signal strength, and which compensates for gain fluctuations due to whether or not the first amplifier is bypassed by switching over the gain of the second amplifier, wherein the time offset between the timing at which the bypass is switched and the timing at which the gain of the second amplifier is switched can be adjusted accurately and also flexibly.

In addition, it is possible to avoid any deterioration in the reception capability due to transient response components in the DC component which is amplified by the gains which differ with the above-described adjustment states of the switching timing.

In accordance with the present invention, there is provided a receiver device comprising: serially-connected first and second amplifiers which amplify a received signal; a switch which causes the received signal to bypass the first amplifier; and a gain control portion which regulates the received signal to a predetermined signal level by controlling the opening and closing of the switch and exerting variable control over the gain of the second amplifier, depending on the incoming signal strength; whereby the gain control portion compensates for gain fluctuations due to the opening and closing of the switch by switching over the gain of the second amplifier; wherein the gain control circuit comprises a digital logic circuit which adjusts a time offset between the open/closing period of the switch and the switching period of the gain of the second amplifier to a previously programmed setting.

The provision of the digital logic circuit which adjusts the previously programmed settings of the time offset between the timing of the opening/closing of the switch and the timing of the gain switching of the second amplifier makes it possible to enable accurate and also flexible adjustment of the time offset between the timing at which the bypass of the first amplifier is switched and the timing at which the gain of the second amplifier is switched.

Such a digital logic circuit could be implemented by incorporating a programmable digital logic circuit which is programmed with time offsets between the switch open/closing period and the gain switching period of the second amplifier. This digital logic circuit could be configured of a field programmable gate array (FPGA), by way of example.

The gain control circuit could also be configured to include a digital logic circuit which is designed to store settings for the time offsets between the switch open/closing period and the gain switching period of the second amplifier in a predetermined memory portion, and also read in the thus-stored settings for use in controlling the opening and closing of the switch and controlling the switching of the gain of the second amplifier.

In addition, the switch open/close control and the switching control of the gain of the second amplifier could be made to have a hysteresis characteristic.

Furthermore, the gain control of the received signal by the gain control portion could be applied to an OFDM receiver device which receives an OFDM signal made up of a plurality of sub-carrier signals. In such a case, the receiver device comprises an orthogonal demodulator which performs orthogonal demodulation of the OFDM signal by a predetermined local signal and a DC component canceler which removes the DC component of the signal which has been subjected to orthogonal demodulation. One of the plurality of sub-carrier signals becomes a null carrier, and the frequency of the predetermined local signal used in orthogonal demodulation is determined to be the frequency at which the null carrier which has been demodulated by this local signal forms the DC component.

Configuring the receiver device in this manner ensures that DC components which have been converted from the null carrier can be ignored, even if the DC offset components of the first and second amplifiers are briefly amplified greatly in response to the switching timing state, and also the DC offset components can be removed by DC component cancelers.

### BRIEF DESCRIPTION OF THE DRAWINGS

The present invention will be more clearly understood from the description as set below with reference to the accompanying drawings, wherein:
Fig. 1 schematically shows an example of the configuration of a prior-art OFDM receiver device which provides an automatic gain control function;
Fig. 2A is illustrative of gain control which the gain control portion 40 performs by using the low-noise amplifier 12;
Fig. 2B is illustrative of gain control of the variable-gain amplifier 16 by the gain control portion 40;
Fig. 2C shows variations in the total gain of Figs. 2A and 2B;
Fig. 3A shows gain variations when the incoming signal strength increases to exceed the threshold value L1 and the timing of the switching of the gain of the variable-gain amplifier is delayed slightly with respect to the timing of the bypassing of the low-noise filter;
Fig. 3B shows the total of the gain due to the low-noise amplifier and the gain of the variable-gain amplifier;
Fig. 4A shows gain variations when the incoming signal strength increases to exceed the threshold value L1 and the timing of the switching of the gain of the variable-gain amplifier is slightly faster than the timing of the bypassing of the low-noise amplifier;
Fig. 4B shows the total of the gain due to the low-noise amplifier and the gain of the variable-gain amplifier;
Fig. 5 schematically shows an example of the configuration of an OFDM receiver device in accordance with a first embodiment of the present invention;
Fig. 6A is a graph of variations in the incoming signal strength of the received signal;
Fig. 6B is a timing chart of the open/close control signal which the RF-SW switching portion generates;
Fig. 6C is a timing chart of the gain command signal which the V-AMP gain determination portion generates;
Fig. 6D is a graph of actual gain variations in the variable-gain amplifier which is controlled in accordance with Fig. 6C;
Fig. 6E is a timing chart of the open/close control signal having timing which has been adjusted by the timing adjustment portion;
Fig. 6F is a graph of variations in the total of the gain due to the low-noise amplifier and the gain of the variable-gain amplifier;
Fig. 7 is a flowchart of an example of the method of determining the set time offset T;
Fig. 8A is a graph of a gain command signal having a hysteresis characteristic, which is generated by the V-AMP gain determination portion 41;
Fig. 8B is a graph of an open/close control signal having a hysteresis characteristic, which is generated by the RF-SW switching portion 42;
Fig. 9 is a flowchart of a method of controlling the opening/closing of the radio-frequency signal switch 52 and the gain of the variable-gain amplifier 16, with a hysteresis characteristic;
Fig. 10 shows the spectrum of an OFDM signal which comprises a null carrier; and
Fig. 11 schematically shows an example of the configuration of an OFDM receiver device in accordance with a second embodiment of the present invention.

### DESCRIPTION OF THE PREFERRED EMBODIMENTS

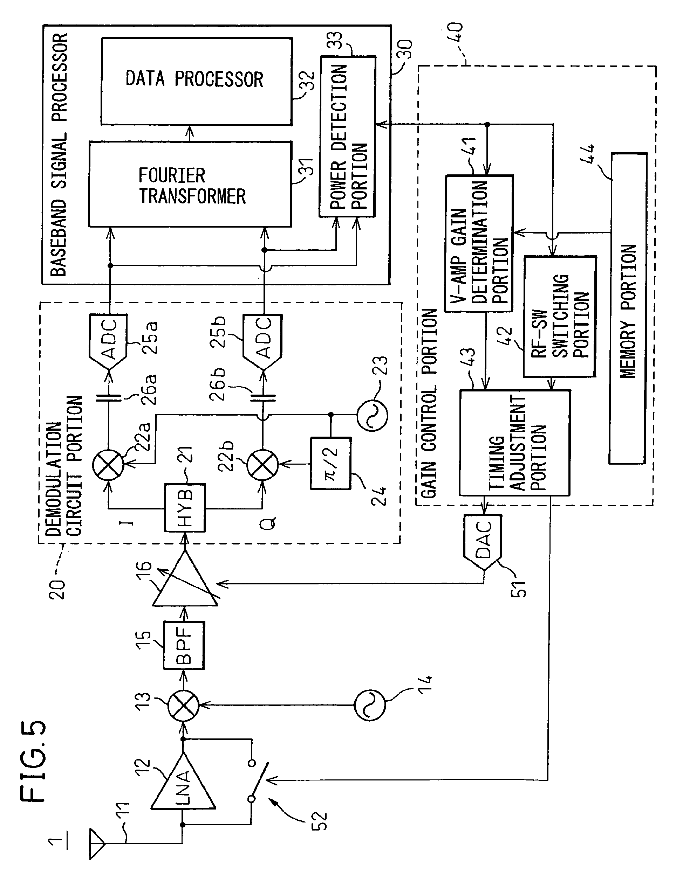

Preferred embodiments of the present invention will be described in detail below while referring to the attached figures. An example of the configuration of an OFDM receiver device in accordance with a first embodiment of the present invention is shown schematically in Fig. 5. Since the OFDM receiver device 1 shown in Fig. 5 has a configuration similar to that of the OFDM receiver device described previously with reference to Fig. 1, components which are the same or similar thereto are denoted by the same reference numbers and further description of the same functions is omitted.

As described previously with reference to Fig. 2A, when the incoming signal strength which the power detection portion 33 has estimated changes from a strength which is below the predetermined signal strength threshold value L1 to a high strength, the RF-SW switching portion 42 closes the radio-frequency signal switch 52 to make the received signal bypass the low-noise amplifier 12. When the incoming signal strength which the power detection portion 33 has estimated changes from a strength which is higher than the predetermined signal strength threshold value L1 to a low strength, the RF-SW switching portion 42 opens the radio-frequency signal switch 52 to halt the bypassing of the low-noise amplifier 12.

In addition, the V-AMP gain determination portion 41 exerts variable control over the gain of the variable-gain amplifier 16 in response to reception strength, in accordance with the gain lines GLL and GLH which reduce the gain as the incoming signal strength increases, as described previously with reference to Fig. 2B. While the incoming signal strength is weaker than the threshold value L1 and the low-noise amplifier 12 is not bypassed, the gain is determined by the gain line GLL which gives a comparatively low gain. While the incoming signal strength is greater than or equal to the threshold value L1 and the low-noise amplifier 12 is bypassed, the gain is determined by the gain line GLH which is the gain G1 greater than the gain line GLL. The gain width G1 is set to the same value as the gain of the low-noise amplifier 12.

To enable the V-AMP gain determination portion 41 to determine the gain of the variable-gain amplifier 16 in accordance with the above-described gain lines GLL and GLH, each gain which the variable-gain amplifier 16 ought to have for each incoming signal strength is written into a gain settings table in which gains are linked to the corresponding incoming signal strengths, and a gain settings table is created for each gain line and is stored in a memory portion 44. The V-AMP gain determination portion 41 reads out the gain corresponding to the incoming signal strength which the power detection portion 33 has estimated from this gain settings table, for use as the gain command value for the variable-gain amplifier 16.

Therefore, when the incoming signal strength which the power detection portion 33 has estimated changes from a strength which is lower than the predetermined signal strength threshold value L1 to a higher strength and the low-noise amplifier 12 is bypassed, the V-AMP gain determination portion 41 switches the gain line to be used in the determination of the gain of the variable-gain amplifier 16 from the comparatively low gain line GLL to the gain line GLH of the low-noise amplifier 12 which is the gain G1 higher, to compensate for gain fluctuations generated by the bypassing of the low-noise amplifier 12.

When the incoming signal strength which the power detection portion 33 has estimated changes from a strength which is higher than the predetermined signal strength threshold value L1 to a lower strength, the V-AMP gain determination portion 41 switches the gain line to be used in the gain determination from the comparatively high gain line GLH to the low gain line GLL which is G1 lower.

Returning to Fig. 5, the gain control portion 40 of this example of the configuration comprises a timing adjustment portion 43 which is formed of a digital logic circuit. This timing adjustment portion 43 inputs a gain command signal for the variable-gain amplifier 16 in digital format which was generated by the V-AMP gain determination portion 41 (hereinafter called simply "gain command signal") and an open/close control signal for the radio-frequency signal switch 52 which was generated by the RF-SW switching portion 42 (hereinafter called simply "open/close control signal").

The timing adjustment portion 43 outputs the gain command signal and the open/close control signal unchanged if there is no open/close control of the radio-frequency signal switch 52. But adjusts the time offset between the open/closing period of the radio-frequency signal switch 52 and the switching period of the gain of the variable-gain amplifier 16 to the setting of the time offset which was set previously (hereinafter called "set time offset"), by adjusting the time offset of the output timing of the open/close signal and the output timing of the open/close control signal if open/close control of the radio-frequency signal switch 52 has occurred.

The timing adjustment portion 43 could be configured as an digital logic circuit implemented by an FPGA, comprising a storage circuit which stores a number of cycles generated by a predetermined clock signal during the set time offset, a detection circuit which detects changes in the gain command signal or open/close control signal which are caused by the incoming signal strength crossing the predetermined threshold value L1, a counter circuit which starts to count the predetermined clock signal for the number of cycles stored in the storage circuit when this change in the signal are caused, and a delay circuit which causes a change in the open/close control signal when the counter circuit completes the count.

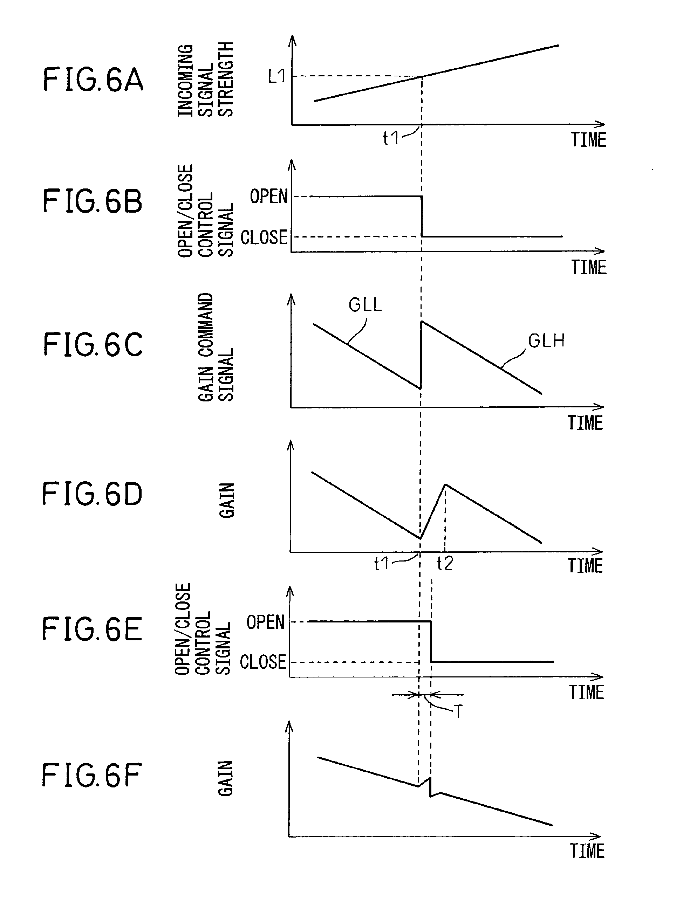

The description now turns to an example of how the timing adjustment portion 43 adjusts the time offset between the open/closing period of the radio-frequency signal switch 52 and the switching period of the gain of the variable-gain amplifier 16, with reference to Figs. 6A to 6F. Fig. 6A is a graph of variations in the incoming signal strength of the received signal, Fig. 6B is a timing chart of the open/close control signal which the RF-SW switching portion 42 generates, Fig. 6C is a timing chart of the gain command signal which the V-AMP gain determination portion 41 generates, Fig. 6D is a graph of actual gain variations of the variable-gain amplifier 16 which is controlled in accordance with the signal shown in Fig. 6C, Fig. 6E is a timing chart of the open/close control signal which has had timing adjusted by the timing adjustment portion 43, and Fig. 6F is a graph of variations in the gain which is the total of the gain due to the low-noise amplifier 12 and the gain due to the variable-gain amplifier 16.

Consider a case in which the in coming signal strength exceeds the predetermined signal strength threshold value L1 for switching the bypassing of the low-noise amplifier 12 at a time t1, while the incoming signal strength is increasing, as shown in Fig. 6A. When that happens, the gain command value of the gain command signal is switched by the RF-SW switching portion 42 changing the open/close control signal from the state in which the radio-frequency signal switch 52 is open to that in which it is closed at the time t1, as shown in Fig. 6B, and the V-AMP gain determination portion 41 switching the gain line used in the gain determination from the comparatively low GLL to GLH, as shown in Fig. 6C.

Since the response speed of the variable-gain amplifier 16 is limited in practice, as described above, the gain of the variable-gain amplifier 16 changes comparatively gently between the time t1 and a time t3 in comparison with the gain command signal, as shown in Fig. 6D.

The timing adjustment portion 43 minimizes fluctuations in the gain which is the total of the gain due to the low-noise amplifier 12 and the gain of the variable-gain amplifier 16, which are generated in the vicinity of the switching time t1 as shown in Fig. 6F, by adjusting the time offset between the timing of the output of the open/close control signal and the timing of the output of the gain command signal to an ideal set time offset T, as shown in Fig. 6E.

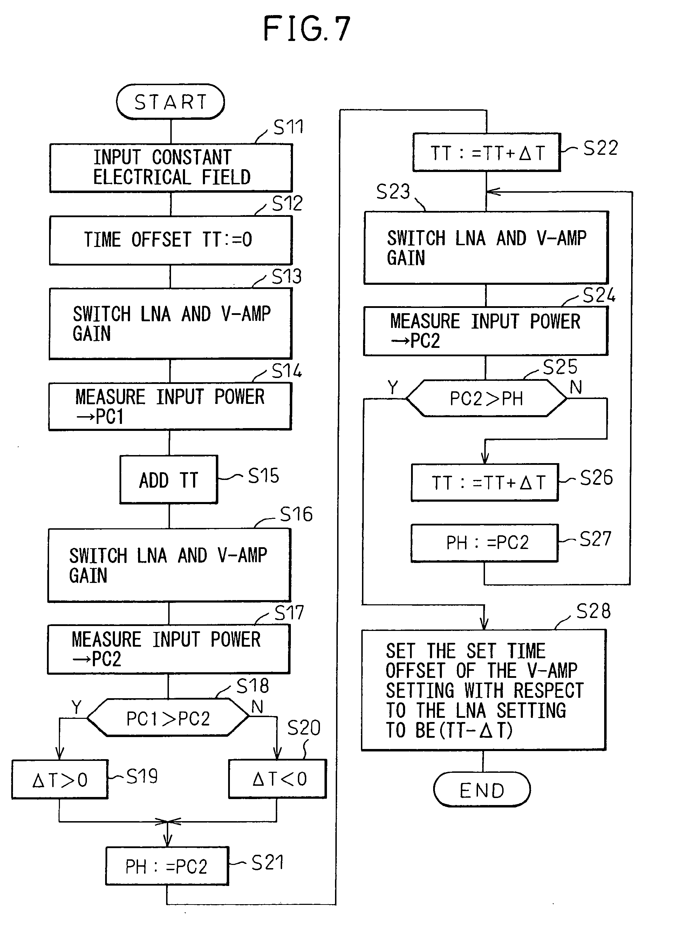

A flowchart of an example of the method of determining the set time offset T is shown in Fig. 7. With this determination method, the switching of the radio-frequency signal switch 52 and the low-noise amplifier 12 is repeated while a time offset TT between the timing at which the open/close control signal is output and the timing at which the gain command signal is output is varied by a predetermined incremental step ΔT, fluctuations in the signal which is input to the demodulation circuit portion 20 which occur during that time are measured, and the time offset TT at which the fluctuation is the smallest is determined to be the set time offset T.

First of all, a constant electrical field is applied to the antenna 11 of the receiver device 1 in which the set time offset is to be determined, in a step S11. Next, in a step S12, the value of the time offset TT between the timing at which the open/close control signal is output and the timing at which the gain command signal is output is set to an initial value of 0.

In a step S13, the time offset TT is 0, in other words, the gain command signal and the open/close control signal after switching are output simultaneously, to perform the bypass switching of the low-noise amplifier 12 and the gain switching of the variable-gain amplifier 16. In a step S14, the fluctuation in the signal strength of the signal which is input to the demodulation circuit portion 20, caused during the switching, is measured and stored in a variable PC1.

In a step S16, the bypass switching of the low-noise amplifier 12 and the gain switching of the variable-gain amplifier 16 are performed in a state in which the time offset TT has been increased (step S15), and fluctuation in the signal strength of the signal which is input to the demodulation circuit portion 20, caused during the switching, is measured and stored in a variable PC2 (step S17).

In a step S18, the variables PC1 and PC2 are compared and, if the value in PC1 is greater than that in PC2 (in other words, if the signal strength fluctuation has been reduced as a result of the increase in the time offset TT), the incremental step ΔT is set to a positive value to ensure that the adjustment is in the direction in which the time offset TT increases (step S19). Conversely, if PC1 is not greater than PC2, the incremental step ΔT is set to a negative value (step S20) .

Subsequently, in a step S21, a power history variable PH for storing a minimum value of the signal strength fluctuations of the signal which is input to the demodulation circuit portion 20, and measured at each time offset TT which is varied sequentially in subsequent steps S23 to S27, is set in the value of PC2 measured at step S17.

In a step S22, the incremental step ΔT which was determined as described above is added to each time offset TT, then the bypass switching of the low-noise amplifier 12 and the gain switching of the variable-gain amplifier 16 are performed (step S23), and the fluctuation in the signal strength of the signal which is input to the demodulation circuit portion 20, caused during the switching, is measured and stored in the variable PC2 (step S24).

In a step S25, it is determined whether or not the signal strength fluctuation value PC2 measured in the previous cycle has increased to more than the minimum value PH for fluctuations measured so far, in other words, whether or not the time offset TT has passed through the optimal adjustment point.

If the signal strength fluctuation value PC2 is smaller than the minimum value PH of fluctuations measured so far, the incremental step ΔT is again added to the time offset TT in a step S26, the minimum value PH is updated to the fluctuation value PC measured in this cycle, in a step S27, the processing returns to step S23, and the steps S23 to S27 are repeated until the signal strength fluctuation value PC2 begins to increase by adding the incremental step ΔT.

If the signal strength fluctuation value PC2 is larger than the minimum value PH of fluctuations measured so far in step S25, the incremental step ΔT is removed from the current time offset TT (TT - ΔT) and the result is determined to be the set time offset in a step S28, and processing ends.

Note that if the response speed of the variable-gain amplifier 16 is different between when the switchover is such as to increase the gain of the variable-gain amplifier 16 (in other words, switching which bypasses the low-noise amplifier 12) and when the switchover is such as to reduce the gain of the variable-gain amplifier 16 (in other words switching to halt the bypassing of the low-noise amplifier 12), the timing adjustment portion 43 could employ different set time offsets as the time offset T between the output timing of the gain command signal and the output timing of the open/close control signal, between during the switchover in which the gain of the variable-gain amplifier 16 increases and that in which it decreases. For that reason, the determination method shown in Fig. 7 is performed in both of the above-described cases, to determine set time offsets which are suitable for each case.

When the receiver device 1 moves, it is considered that the incoming signal strength could fluctuate in a direction from strong to weak, or from weak to strong, but when the receiver device 1 does not move, for example, it is considered that a constant reception strength is maintained. If the incoming signal strength of the receiver device 1 is maintained in the vicinity of the predetermined threshold value L1 for switching of the bypass of the low-noise amplifier 12, it is thought that the reception characteristic could deteriorate due to frequent bypass control switching.

In such a case, the thus-configured receiver device 1 has two threshold values for the incoming signal strength for the switchover of the radio-frequency signal switch 52 and the gain switching of the variable-gain amplifier 16, and hysteresis characteristics are provided in the switchover control of the radio-frequency signal switch 52 by the RF-SW switching portion 42 and the gain switching control of the variable-gain amplifier 16 by the V-AMP gain determination portion 41.

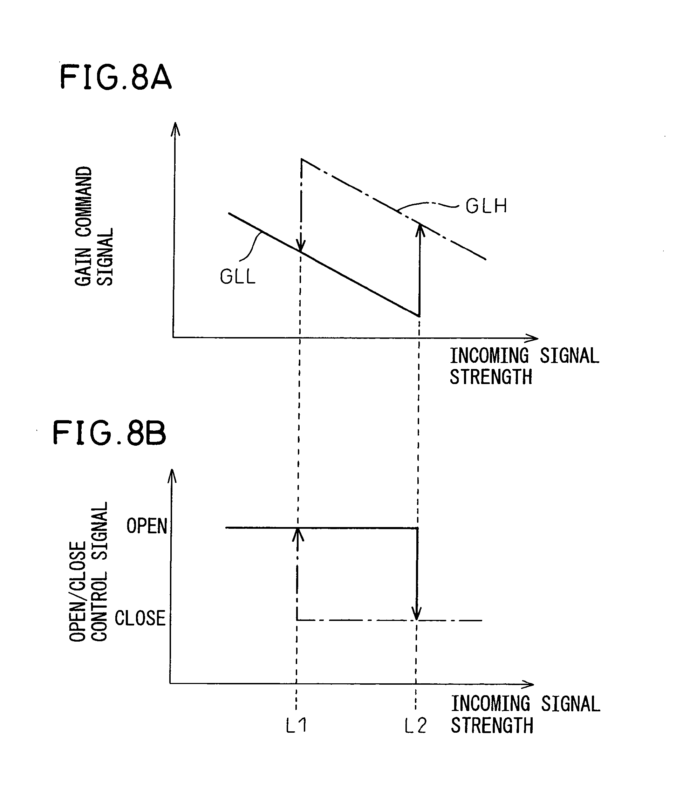

A graph of a gain command signal having a hysteresis characteristic which is generated by the V-AMP gain determination portion 41 is shown in Fig. 8A and a graph of an open/close control having a hysteresis characteristic which is generated by the RF-SW switching portion 42 is shown in Fig. 8B.

First of all, the comparatively low threshold value L1 and a comparatively high L2 are specified in the V-AMP gain determination portion 41 and the RF-SW switching portion 42 as threshold values for the gain switching control of the variable-gain amplifier 16 and for the switchover control of the radio-frequency signal switch 52. These threshold values could also be previously programmed into the logic circuits which make up the V-AMP gain determination portion 41 and the RF-SW switching portion 42, or they could be stored in an external storage element and read out for use, as will be described later.

As shown by the solid line in Fig. 8A, the V-AMP gain determination portion 41 performs variable control over the gain of the variable-gain amplifier 16 in accordance with the gain line GLL, which has a comparatively low gain, once the incoming signal strength has fallen below the comparatively low threshold value L1 and until the incoming signal strength subsequently reaches the comparatively high threshold value L2. Once the incoming signal strength exceeds the comparatively high threshold value L2, the V-AMP gain determination portion 41 performs the variable control over the gain of the variable-gain amplifier 16 in accordance with the gain line GLH, which has a comparatively high gain, until the reception strength reaches the comparatively low threshold value L1, as shown by the broken line.

Similarly, the RF-SW switching portion 42 puts the radio-frequency signal switch 52 into the open state once the incoming signal strength has fallen below the comparatively low threshold value L1 and until the incoming signal strength subsequently reaches the comparatively high threshold value L2, as shown by the solid line in Fig. 8B. Once the incoming signal strength exceeds the comparatively high threshold value L2, the RF-SW switching portion 42 puts the radio-frequency signal switch 52 into the closed state until the incoming signal strength subsequently reaches the comparatively high threshold value L2, as shown by the broken line.

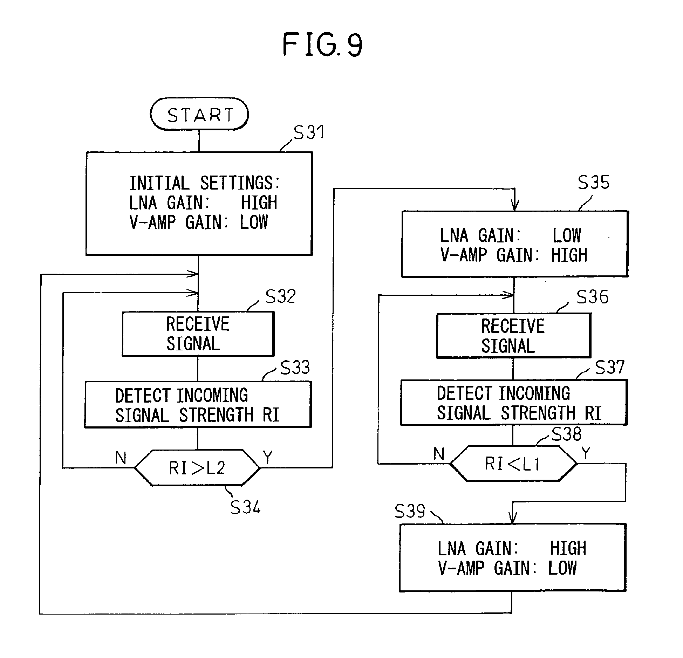

A flowchart of the method of controlling the opening/closing of the radio-frequency signal switch 52 and the gain of the variable-gain amplifier 16, using hysteresis characteristics, is shown in Fig. 9.

First of all, at a step S31 at the start of operation of the receiver device 1, the RF-SW switching portion 42 outputs the open/close control signal to put the radio-frequency signal switch 52 into the open state, so that the received signal is amplified by the low-noise amplifier 12, and the V-AMP gain determination portion 41 uses the gain line GLL, having a comparatively low gain, to perform variable control of the gain of the variable-gain amplifier 16.

If the OFDM receiver device 1 receives a signal in a step S32, the power detection portion 33 detects an incoming signal strength RI of the received signal at a step S33.

At a step S34, the RF-SW switching portion 42 and the V-AMP gain determination portion 41 determine whether or not the incoming signal strength RI has exceeded the comparatively high threshold value L2 and, if the incoming signal strength RI has not exceeded the threshold value L2, the processing returns to step S32 and steps S32 to S34 are repeated. During this time, the radio-frequency signal switch 52 remains open and the V-AMP gain determination portion 41 continues the gain control of the variable-gain amplifier 16, still using the gain line GLL.

If the incoming signal strength RI has exceeded the threshold value L2 in step S34, the RF-SW switching portion 42 switches the value of the open/close control signal to the value which puts the radio-frequency signal switch 52 in the closed state, so that the received signal bypasses the low-noise amplifier 12, and the V-AMP gain determination portion 41 switches the gain line used in the control of the variable-gain amplifier 16 to the comparatively high gain line GLH at step S35.

When the receiver device 1 receives the signal subsequently at step S36, the power detection portion 33 detects the incoming signal strength RI of the received signal at step S37.

At step S38, the RF-SW switching portion 42 and the V-AMP gain determination portion 41 determine whether or not the incoming signal strength RI has fallen below the comparatively low threshold value L1 and, if the incoming signal strength RI has not fallen below the threshold value L1 the processing returns to step S36 and steps S36 to S38 are repeated. During this time, the radio-frequency signal switch 52 remains in the closed state and the V-AMP gain determination portion 41 continues the gain control of the variable-gain amplifier 16, still using the gain line GLH.

If the incoming signal strength RI has fallen below the threshold value L1 at step S38, the RF-SW switching portion 42 switches the value of the open/close control signal to the value which sets the radio-frequency signal switch 52 to the open state, so that the received signal is amplified by the low-noise amplifier 12, and the V-AMP gain determination portion 41 switches the gain line used in the gain control of the variable-gain amplifier 16 to the comparatively low gain line GLL, and then the processing returns to S32.

The provision of these hysteresis characteristics to the switchover control of the radio-frequency signal switch 52 and the gain switching control of the variable-gain amplifier 16 ensures that no bypass control is applied so long as there are no fluctuations in the incoming signal strength which reach as far as one of the two threshold values L1 and L2, if bypass control has been activated by the other threshold value, thus making it possible to restrain the frequency at which bypass control is switched. Note that the threshold values L1 and L2 are preferably set by conversions which suit the elements and circuit configuration of the receiver device 1, as well as the characteristics of the circuitry as a whole (such as the NF characteristics thereof).

Even if the time offset between the open/close timing of the radio-frequency signal switch 52 and the timing of the gain switching of the variable-gain amplifier 16 is adjusted optimally, the gain line for the entire receiver device 1 will not be a complete straight line; a slight gain fluctuation will occur at the switching, as shown in Fig. 6F. In addition, there is a danger that the transient response components of the DC offset component of the low-noise amplifier 12 and the variable-gain amplifier 16 will be amplified by such gain fluctuations, reducing the reception capability.

For example, since the DC offset components of the low-noise amplifier 12 and the variable-gain amplifier 16 become input offsets at the analog-digital converters 25a and 25b which convert analog baseband signals into digital baseband signals, the dynamic ranges of the analog-digital converters 25a and 25b will be compressed by any increase in these DC offset components, which leads to a deterioration in the S/N ratio of the digital baseband signal.

In the present example of the configuration, deterioration of the reception capability due to transient response components of the DC offset components in this example of the configuration can be avoided by allocating a null carrier (a carrier component which does not include a significant signal) to a sub-carrier of the plurality of sub-carrier signals which make up the OFDM signal which is converted into the DC component in the demodulation circuit portion 20, and removing the DC offset components of the low-noise amplifier 12 and the variable-gain amplifier 16 at the previous stage of the analog-digital converters 25a and 25b.

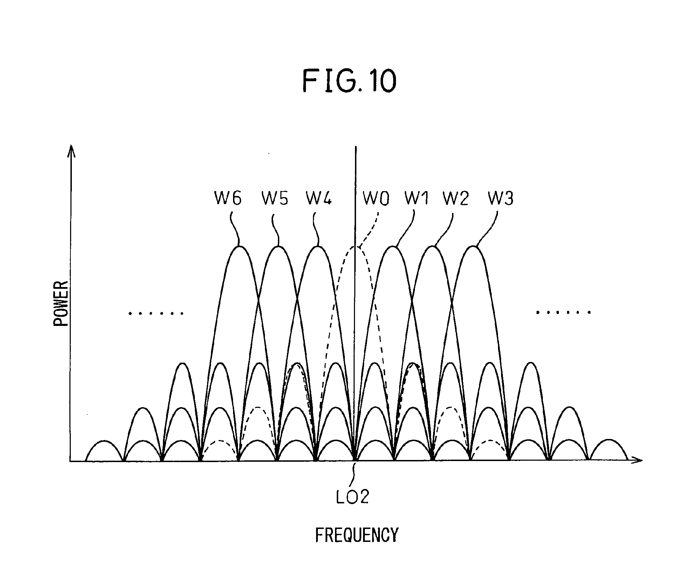

The spectrum of an OFDM received signal which has passed through the frequency converter 13 and been converted into an intermediate-frequency signal is shown in Fig. 10. As shown in this figure, the OFDM received signal comprises a plurality of sub-carrier signals W0 to W6 which are allocated to different frequency bands.

Of this plurality of sub-carrier signals, the sub-carrier W0 which has the central frequency of its carrier frequency band, which is identical to the frequency of the local signal which the demodulation circuit portion 20 uses in the orthogonal demodulation (orthogonal detection), is converted into the DC signal component by the orthogonal demodulation of the demodulation circuit portion 20. By allocating the null carrier to this sub-carrier, it becomes possible to ignore the DC signal components comprised within the analog baseband signal.

Thus, of the plurality of sub-carrier signals which make up the OFDM signal, the sub-carrier signal which is converted into the DC component by the orthogonal demodulation is determined to correspond to the frequency L02 of the local signal which is used in the orthogonal demodulation and is taken as the null carrier. The device comprises DC component cancelers 26a and 26b configured of high-pass filters or the like which remove the DC component from the analog baseband signal which has been converted by the orthogonal demodulation, to remove the DC offset components of the low-noise amplifier 12 and the variable-gain amplifier 16, together with the DC components generated by the conversion of the null carrier.

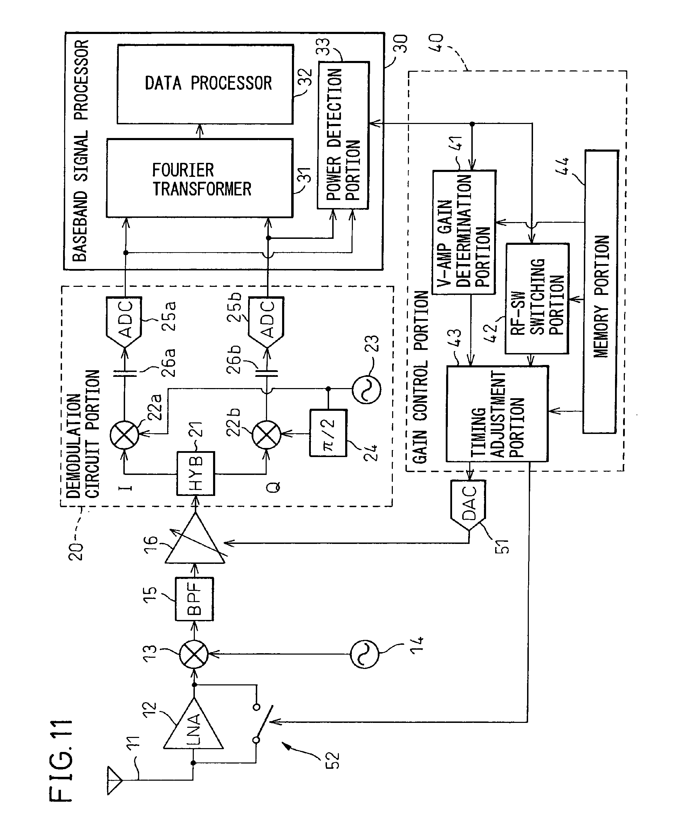

An example of the configuration of an OFDM receiver device in accordance with a embodiment example of the present invention is shown in Fig. 11. With this configuration, the set time offset T which is designated as a time offset between the open/closing period of the radio-frequency signal switch 52 and the switching period of the gain of the variable-gain amplifier 16 as described above is stored beforehand in the memory portion 44.

The timing adjustment portion 43 is implemented by a digital logic circuit, in a similar manner to that described above with reference to Fig. 5, but instead of having the set time offset T programmed beforehand into the timing adjustment portion 43 as in the configurational example of Fig. 5, the set time offset T which is stored in the memory portion 44 is read out therefrom, and the time between the open/closing period of the radio-frequency signal switch 52 and the switching period of the gain of the variable-gain amplifier 16 is adjusted to this set time offset T.

In this example of the configuration, the RF-SW.. switching portion 42 and the V-AMP gain determination portion 41 perform the switching control over whether or not the low-noise amplifier 12 is to be bypassed and the gain switching control of the variable-gain amplifier 16, and also the threshold value L1 for switching of the bypass of the low-noise amplifier 12 is stored in the memory portion 44. The RF-SW switching portion 42 and the V-AMP gain determination portion 41 use the threshold value L1 which is read out from the memory portion 44 at the start of operation of the receiver device 1, to determine whether or not switching of the bypass of the low-noise amplifier 12 is necessary and whether or not the gain switching of the variable-gain amplifier 16 is necessary.

Note that in this example of the configuration as well, two threshold values L1 and L2 can be provided for switching of the bypass of the low-noise amplifier 12, and hysteresis characteristics can be provided for the switchover control over the radio-frequency signal switch 52 by the RF-SW switching portion 42 and the gain switching control of the variable-gain amplifier 16 by the V-AMP gain determination portion 41. These two incoming signal strength threshold values L1 and L2 can also be stored in the memory portion 44, so that the RF-SW switching portion 42 and the V-AMP gain determination portion 41 can read them out.

The present invention makes it possible to set both the timing of the switching of bypassing of one of a plurality of serially-connected amplifiers and the timing of gain switching of another of those amplifiers, accurately and also flexibly.

It also enables easy removal of DC offset components in the amplifies caused by the switching timing state, even if those components have been amplified.

Since a digital logic circuit is used instead of the time constant circuit of the prior art, the timing adjustment portion can be incorporated into an integrated logic circuit in a conventional receiver device, thus improving the reception characteristics without increasing the number of components or the cost.

The present invention can be applied to a receiver device which performs automatic gain control to regulate a received signal to a predetermined signal strength.

While the invention has been described with reference to specific embodiments chosen for purpose of illustration, it should be apparent that numerous modifications could be made thereto by those skilled in the art, without departing from the basic concept and scope of the invention.

## Claims

1. A receiver device (1) having serially connected first and second amplifiers (12, 16) which amplify a received signal, a switch (52) which causes said received signal to bypass said first amplifier (12), and a gain control portion (40) which regulates said received signal to a predetermined signal level by controlling the opening and closing of said switch (52) and exerting variable control over the gain of said second amplifier (16), depending on the incoming signal strength of said received signal; wherein said gain control portion (40) compensates for gain fluctuations due to the opening and closing of said switch (52) by switching over the gain of said second amplifier (16);
wherein said gain control circuit (40) comprises a digital logic circuit (43) which adjusts a time offset between the open/closing period of said switch (52) and the switching period of the gain of said second amplifier (16) to a previously programmed setting.

2. The receiver device as set forth in claim 1, wherein:
said digital logic circuit (43) is a programmable digital logic board which has been previously programmed with a time offset between the open/closing period of said switch (52) and the gain switching period of said second amplifier (16).

3. The receiver device as set forth in claim 1, wherein:
said gain control circuit (40) further comprises a memory portion (44) in which is previously stored a setting of a time offset between the open/closing period of said switch (52) and the gain switching period of said second amplifier (16); and
said digital logic circuit (43) adjusts the time offset between the open/closing period of said switch (52) and the gain switching period of said second amplifier (16) to said stored setting.

4. The receiver device as set forth in claim 1, wherein:
the open/close control of said switch (52) and the switching control of the gain of said second amplifier (16) performed by said gain control portion (40) have a hysteresis characteristic.

5. The receiver device as set forth in claim 1, wherein:
said received signal is an orthogonal frequency-division multiplexed signal formed of a plurality of sub-carrier signals including a null carrier;
said receiver device (1) comprises a orthogonal demodulator (22a, 22b), which performs orthogonal demodulation on an orthogonal frequency-division multiplexed signal with a predetermined local signal, and a DC component canceler (26a, 26b), which removes a DC component of an orthogonally demodulated signal; and
the frequency of said predetermined local signal is determined to be the frequency at which said null carrier which has been demodulated by said local signal forms a DC component.
